# EUROPEAN PATENT SPECIFICATION

(11) **EP 0 951 052 B1**
(45) Date of publication and mention of the grant of the patent: **15.12.2004**
(21) Application number: 99302180.7
(22) Date of filing: 22.03.1999
(51) Int. Cl.: H01L 21/00

(54) **Bubbler apparatus and condenser for use with the bubbler apparatus**
Sprudelvorrichtung und Kondensator dafür
Appareil à effervescence et condenseur pour utiliser avec

(30) Priority: 27.03.1998 JP 8135398
(43) Date of publication of application: 20.10.1999
(73) Proprietor: Komiya, Kosho, Abiko-shi, Chiba-ken (JP)
(72) Inventor: Komiya, Kosho, Abiko-shi, Chiba-ken (JP)
(74) Representative: Eddowes, Simon

(56) References cited:
- PATENT ABSTRACTS OF JAPAN vol. 010, no. 123 (C-344), 8 May 1986 (1986-05-08) & JP 60 248228 A (SUMITOMO DENKI KOGYO KK), 7 December 1985 (1985-12-07)
- PATENT ABSTRACTS OF JAPAN vol. 017, no. 496 (C-1108), 8 September 1993 (1993-09-08) & JP 05 131126 A (APURIORI KK), 28 May 1993 (1993-05-28)
- PATENT ABSTRACTS OF JAPAN vol. 012, no. 450 (C-547), 25 November 1988 (1988-11-25) & JP 63 176328 A (SUMITOMO ELECTRIC IND LTD), 20 July 1988 (1988-07-20)

## Description

### BACKGROUND OF THE INVENTION

### Field of the Invention

This invention relates to a condenser which can be employed in bubbler apparatuses for manufacturing semiconductors, optical fibers, liquid crystal panels, or the like, and a gas-laser oscillator, for feeding thereto a source contained in a gas mixture in a desired concentration.

### Prior Art

Conventionally, a bubbler apparatus of this kind has been proposed e.g. by Japanese Laid-Open Patent Publication (Kokai) No. 60-248228, which blows a carrier gas controlled at a constant flow rate into a source in a liquid phase (hereinafter referred to as "liquid source") held in a bubbler vessel to carry out bubbling of the liquid source by using the carrier gas to produce a gas mixture of the carrier gas and the vaporized source. The gas mixture thus produced is cooled by a condenser to a desired temperature at which condensation of the vaporized source occurs to thereby form a saturated vapor of the source at the desired temperature, whereby the vaporized source contained in the gas mixture (or the saturated vapor) in a predetermined concentration is fed to a reactor.

Generally, in a bubbler apparatus, so long as a liquid source held in a bubbler vessel can be constantly maintained at a predetermined temperature, the concentration (at a time point of generation) of the vaporized source in the gas mixture fed to a reactor as well should be maintained constant irrespective of the flow rate of the carrier gas. Actually, however, the concentration of the vaporized source is widely varied depending on the shape and hole diameter of a bubbler nozzle or a change in the level of the liquid source in the bubbler vessel. To overcome this problem, the proposed bubbler apparatus is configured such that the condenser is connected to an outlet port of the bubbler vessel to cause the vaporized source in the gas mixture sent from the bubbler vessel to condense at the desired temperature which is slightly lower than the temperature of the vessel.

However, in the proposed bubbler apparatus, the gas mixture flows through a spiral tube arranged within the casing of the condenser, and the temperature of the gas mixture is controlled by causing hot water to circulate through the inside of the casing where the spiral pipe is arranged. This arrangement of the condenser cannot provide control of the temperature of the gas mixture in quick response to a change in the temperature thereof, and also makes it difficult to detect the true or approximately true temperature of the gas mixture flowing through the spiral tube. For this reason, the condenser cannot be maintained at a desired temperature, inevitably causing a variation in concentration of the vaporized source. As result, it is difficult to keep constant the amount of the source taken out of the bubbler vessel to the reactor (feed rate represented by "the flow rate of the carrier gas x the concentration of the source in the gas mixture x K, wherein K is a constant, which is set to a value of about 1 in the case of a solid source, such as TMI (trimethyl indium), and in a range of 1 to 2, in the case of a liquid source").

### SUMMARY OF THE INVENTION

It is an object of the invention to provide a bubbler apparatus which is capable of feeding a source to a reactor block in a fixed concentration thereof in a gas mixture of a carrier and the source, and at a constant feed rate "or bulk flow", and a condenser for use with the bubbler apparatus.

There is therefore provided a condenser for use in cooling a gas mixture of a carrier gas and a source supplied from a bubbler vessel of a bubbler apparatus to a desired temperature at which condensation of said source occurs to thereby provide a saturated vapor of said source at said desired temperature,
said condenser comprising:
a static mixer which can be connected to a piping, wherein said static mixer includes:
   a pipe defining a passage through which flows said gas mixture supplied from said bubbler vessel; and
   at least one pair of mixing elements for mixing and stirring said gas mixture flowing through said pipe in a manner such that part of said gas mixture at a peripheral portion of said passage and part of said gas mixture at a central portion of said passage are replaced with each other;
a holding member made of a material having a high thermal conductivity and enclosing a whole periphery of said mixer;
a temperature sensor attached to said holding member, for detecting the temperature of said holding member;
temperature adjust means for adjusting the temperature of said holding member comprising at least one of heating means for heating the holding member and cooling means for cooling the holding member;
   and
control means for controlling the at least one of the heating means and the cooling means in response to a temperature value detected by said temperature sensor in a manner such that said gas mixture flowing through said static mixer is maintained at a predetermined temperature.

There is further provided a bubbler apparatus comprising a condenser of the invention and further comprising a bubbler vessel holding a source and having a carrier gas brown therein at a controlled flow rate to provide a gas mixture of said carrier gas and said source by bubbling, and a condenser for cooling said gas mixture to a desired temperature at which condensation of said source occurs to provide a saturated vapor of said source at said desired temperature, said source contained in said gas mixture in a desired concentration as said saturated vapor being fed to a reactor block.

According to this condenser, the gas mixture sent from the bubbler vessel is mixed as it flows through the static mixer, to thereby achieve a uniform temperature distribution of the gas mixture. The temperature of the gas mixture is transmitted to the holding member made of a material having a high thermal conductivity. This makes the temperature of the holding member approximately equal to a true temperature of the gas mixture in the static mixer. When the temperature of the holding member is detected by the temperature sensor, it is possible to detect a temperature close to the true temperature of the gas mixture in the static mixer. Therefore, by controlling the heating means and the cooling means such that the temperature value detected by the temperature sensor becomes equal to a desired temperature, it is possible to cause the source in the gas mixture flowing in the static mixer to always condense at the predetermined temperature. This makes it possible to always feed the source contained in the gas mixture in a fixed concentration from the condenser to the reactor block.

By controlling at least one of the heating means and the cooling means such that the temperature value detected by the temperature sensor becomes equal to the desired temperature, it is possible to carry out the temperature control of the condenser more efficiently with higher accuracy.

The static mixer includes a pipe defining a passage through which flows the gas mixture supplied from the bubbler vessel, and at least one pair of mixing elements for mixing and stirring the gas mixture flowing through the pipe in a manner such that part of the gas mixture at a peripheral portion of the passage and part of the gas mixture at a central portion of the passage are replaced with each other.

The gas mixture flowing through the pipe of the static mixer is mixed and stirred such that part of the mixture gas at a peripheral portion of the passage in the pipe and part of the same at a central portion of the same are replaced with each other, so that the gas mixture is caused to have a more uniform temperature distribution, and it becomes possible to control the temperature of the condenser with higher accuracy based on the temperature detected by the temperature sensor, which is closer to the true temperature of the gas mixture, whereby the source in the gas mixture is caused to constantly condense at the predetermined temperature.

Preferably, the mixing elements of the static mixer are made of a material having a high thermal conductivity.

According to this preferred embodiment, the heat of the gas mixture flowing through the pipe is transmitted to the holding member via the mixing elements made of the material having a high thermal conductivity, whereby the temperature of the holding member detected by the temperature sensor is made closer to the true temperature of the gas mixture, so that it becomes possible to control the temperature of the condenser with higher accuracy based on the thus detected temperature closer to the true temperature of the gas mixture. As a result, the source in the gas mixture can be caused to constantly condense at the predetermined temperature.

More preferably, the pipe of the static mixer and the holding member are made of a material having a high thermal conductivity in a manner such that the pipe and the holding member form a unitary flow path-forming member, the flow path-forming member defining a through hole therein through which the gas mixture flows and which is provided with the at least one pair of mixing elements therein, the temperature sensor detecting a temperature of the flow path-forming member.

According to this preferred embodiment, the heat of the gas mixture flowing in the through hole of the flow path-forming member is directly transmitted to the flow path-forming member made of a material having a high thermal conductivity, and at the same time the temperature of the flow path-forming member is detected by the temperature sensor. Hence, the temperature detected by the temperature sensor is made closer to the true temperature of the gas mixture, so that it becomes possible to control the temperature of the condenser with higher accuracy based on the thus detected temperature closer to the true temperature of the gas mixture. As a result, the source in the gas mixture is caused to constantly condense at the predetermined temperature.

Preferably, the cooling means comprises thermoelectric conversion elements arranged in a manner such that the thermoelectric conversion elements each have a heat absorption surface thereof in contact with an outer surface of the holding member, for cooling the holding member, and auxiliary cooling means for cooling a heat dissipation surface of each of the thermoelectric conversion elements.

According to this preferred embodiment, the holding member is cooled by the heat absorption surface of each thermoelectric conversion element, while the heat dissipation surface of each thermoelectric conversion element is cooled by the auxiliary cooling means, which makes it possible to efficiently cool the condenser to the desired temperature. This makes it possible to preserve the desired temperature of the gas mixture in quick response to a change in the detected temperature of the condenser.

The above and other objects, features, and advantages of the invention will become more apparent from the following detailed description taken in conjunction with the accompanying drawings.

### BRIEF DESCRIPTION OF THE DRAWINGS

FIG. 1 is an exploded perspective view of a condenser for use with a bubbler apparatus according to an embodiment of the invention;
FIG. 2 is a diagram schematically showing the whole arrangement of the bubbler apparatus according to the embodiment;
FIG. 3 is a longitudinal sectional view of the FIG. 1 condenser;
FIG. 4 is a plan view of the FIG. 1 condenser;
FIG. 5 is a side view of the FIG. 1 condenser, as viewed from a lower side of FIG. 4;
FIG. 6 is a side view of the FIG. 1 condenser as viewed from a right side of FIG. 4; and
FIG. 7 is a longitudinal sectional view of a static mixer for use with the FIG. 1 condenser.

### DETAILED DESCRIPTION

The invention will now be described in detail with reference to drawings showing an embodiment thereof. The bubbler apparatus according to the embodiment is used with a semiconductor-manufacturing apparatus to feed a deposition source material thereto. The bubbler apparatus can be employed not only in the semiconductor-manufacturing apparatus but also in an apparatus for manufacturing optical fibers or liquid crystal panels, or a gas-laser oscillator that is required to be stably supplied with a gas mixture containing a source in a predetermined concentration.

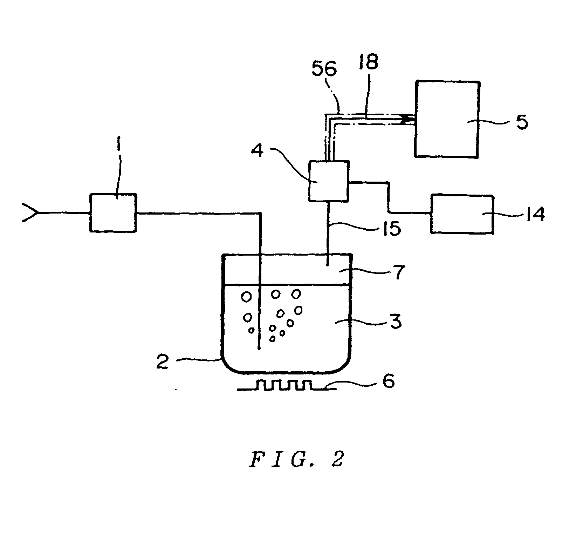

Referring first to FIG. 2, the bubbler apparatus blows a carrier gas controlled by a mass flow controller 1 at a constant flow rate into a source 3 in a liquid phase held in a bubbler vessel (bubbler bottle) 2 to thereby carry out bubbling of the liquid source 3 by using the carrier gas to produce a gas mixture of the carrier gas and the vaporized source 3. The gas mixture is cooled by a condenser 4 to a desired temperature (e.g. 40 °C) at which condensation of the source 3 occurs to provide a saturated vapor of the source at the desired temperature, and the saturated vapor is fed to a reactor 5. The bubbler vessel 2 is heated by a heater 6 such that the gas mixture is maintained at a predetermined temperature (e.g. 50 °C).

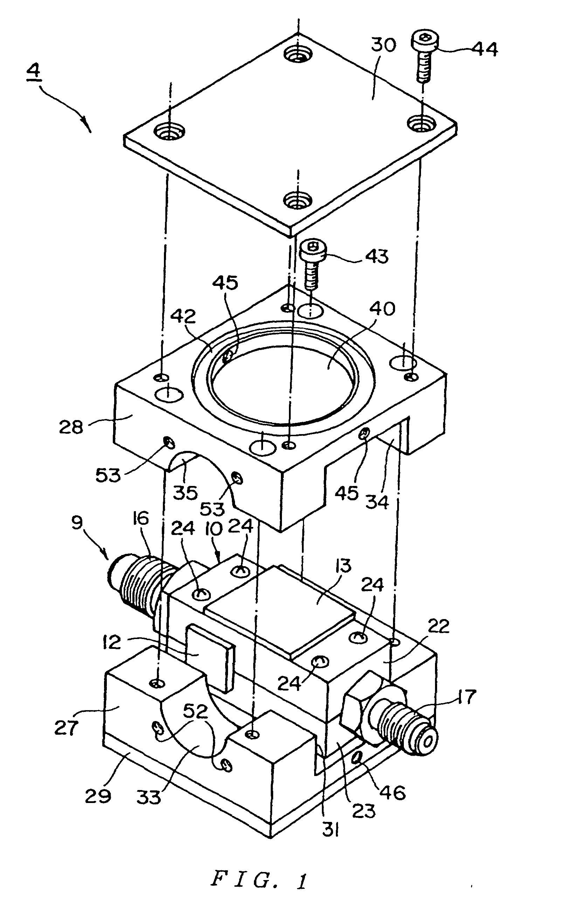

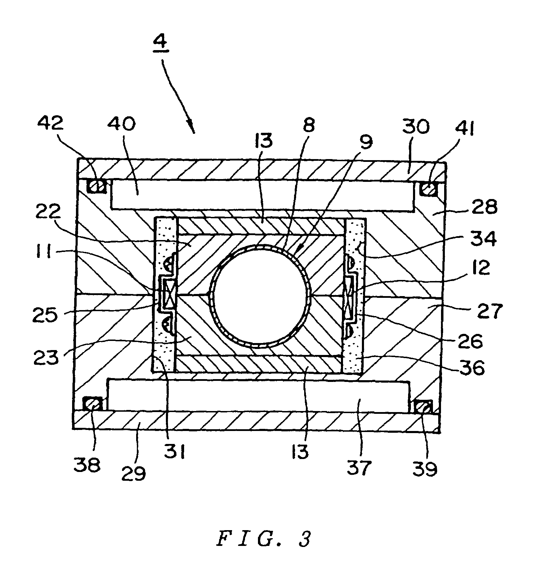

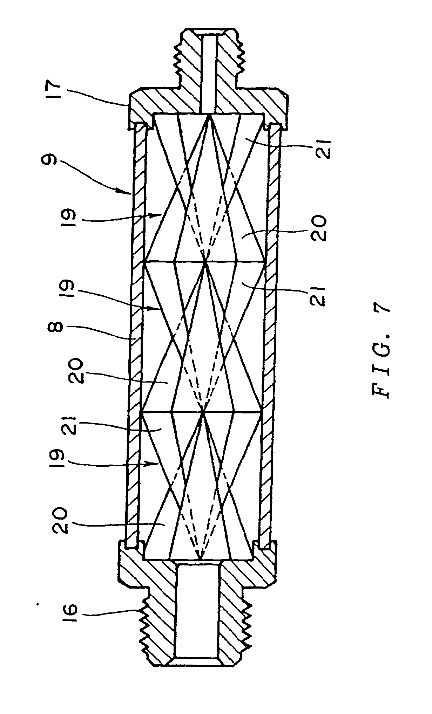

As shown in FIGS. 1 and 3, the condenser 4 includes a static mixer 9 having a pipe 8 (see FIG. 7) connected to a mixture outlet side of the bubbler vessel 2, for mixing the gas mixture sent from the bubbler vessel 2 in the mixer pipe 8, a holding member 10 made of a material having a high thermal conductivity and enclosing the whole periphery of the pipe 8 of the static mixer 9, and a temperature sensor 11 for detecting a temperature of the holding member 10. Further, the condenser 4 includes heaters 12 for heating the holding member 10, and thermoelectric conversion elements 13 for cooling the holding member 10. The condenser 4 is configured such that a condenser control unit 14 (see FIG. 2) controls the heaters 12 and the thermoelectric conversion elements 13 in response to an output (detection value) from the temperature sensor 11, to maintain the temperature of the gas mixture flowing through the mixer pipe 8 at a desired temperature (e.g. 40 °C).

The pipe 8 of the static mixer 9 is connected to the mixture outlet side of the bubbler vessel 2 such that the vaporized source 3 having condensed to a liquid in the mixer pipe 8 can drop into the bubbler vessel 2 or flow down an inner wall of the mixer pipe 8 to return to the bubbler vessel 2. More specifically, the mixer pipe 8 is connected to a pipe 15 in a manner extending upward from the pipe 15. The pipe 15 has a lower end thereof arranged in an upper space 7 of the bubbler vessel 2 and extends upward to have an upper end thereof connected to the mixer pipe 8 (see FIG. 2). The mixer pipe 8 has pipe fittings 16, 17 provided at opposite ends thereof (see FIG. 7). The pipe fittings 16, 17 are so-called face seal fittings, whose flanges are rigidly and air-tightly fixed to the opposite ends of the mixer pipe 8 by electron beam welding or the like, whereby the pipe fittings 16, 17 and the mixer pipe 8 are integrally connected to each other. The pipe fitting 16 on a mixture inlet side of the mixer pipe 8 is connected to the pipe 15, while the pipe fitting 17 on a saturated vapor-outlet side of the mixer pipe 8 is connected to a saturated vapor inlet of the reactor 5 via a pipe 18 (see FIG. 2).

The static mixer 9 has mixing elements 19 for mixing and stirring the gas mixture flowing through the mixer pipe 8 in a manner such that part of the gas mixture at a peripheral portion of a passage defined within the pipe 8 and part of the gas mixture at a central portion of the same are replaced with each other. In the present embodiment, three pairs of mixing elements 19 are arranged in the mixer pipe 8. Each mixing element 19 is comprised of a first guide plate group 20 for guiding part of the gas mixture flowing at the peripheral portion of the passage of the pipe 8 to the central portion of the same and a second guide plate group 21 for guiding part of the gas mixture flowing at the central portion of the passage within the pipe 8 to the peripheral portion of the same. Each of the guide plate groups 20, 21 is comprised of three triangular guide plates. It is preferred that "Static Mixer", for instance, disclosed in Japanese Patent No. 1942734 (Japanese Patent Publication (Kokoku) No. 6-071542) owned by the present applicant is used as the above static mixer 9. Although in the present embodiment, the above patented static mixer is employed as the static mixer 9, this is not limitative, but any static mixer may be used so long as it is capable of mixing and stirring a gas mixture flowing through the mixer pipe 8 in a manner such that part of the gas mixture flowing at a peripheral portion of a passage within the pipe 8 and part of the gas mixture flowing at a central portion of the same are replaced with each other, thereby attaining the uniform temperature distribution of the gas mixture. Further, the mixer pipe 8 is made of a corrosion-resistant material, such as stainless steel or the like.

The pipe fitting 16 on the mixture inlet side of the static mixer 9 has an internal diameter which is large enough to cause the source having condensed in the mixer pipe 8 and dropping down in the mixer pipe 8 to positively return to the bubbler vessel 2 and at the same time not to hinder the gas mixture from entering the mixer pipe 8. More specifically, the internal diameter of the pipe fitting 16 on the mixture inlet side of the mixer pipe 8 is made sufficiently large so as to prevent the condensed liquid source from joining to the liquid source adhering to the inner wall of the pipe fitting 16 and blocking the passage of the gas mixture to stop the flow of the gas mixture into the static mixer 9. On the other hand, the pipe fitting 17 on the saturated vapor outlet side of the mixer pipe 8 is only required to have an internal diameter large enough not to hinder the flow of the saturated vapor and hence made smaller than that of the pipe fitting 16 on the mixture inlet side.

The holding member 10 is comprised of a pair of holding. bodies 22, 23, as shown in FIGS. 1 and 3. Each of the holding bodies 22, 23 is in the form of a rectangular parallelepiped provided with a concave portion which has a semicylindrical shape and is in contact with an outer surface of the mixer pipe 8. By arranging the concave portions of the holding bodies 22, 23 in contact with the outer surface of the mixer pipe 8 and at the same time causing flat surfaces of the same on the concave portion sides of the holding bodies 22, 23 to abut each other, the whole periphery of the mixer pipe 8 is enclosed by the holding member 10. That is, in a state where the holding member 10 encloses the mixer pipe 8, as described above, the holding bodies 22, 23 of the holding member 10 are rigidly secured to each other by bolts 24 at four locations. Each of the holding bodies 22, 23 is made of a material having a high thermal conductivity, such as a metal material, e.g., copper and silver, or a ceramic material, e.g. beryllia ceramics, or the like.

The temperature sensor 11 is fixed to an outer surface of the holding member 10 by a retainer 25. An output signal from the temperature sensor 11 is delivered to the condenser control unit 14. Although in the present embodiment, the temperature sensor 11 is fixed to the outer surface of the holding member 10, this is not limitative, but the temperature sensor 11 may be embedded in the inside of the holding member 10. In such a case, it is possible to detect a temperature closer to the true temperature of the gas mixture flowing through the mixer pipe 8 of the static mixer 9.

The heaters 12 are fixed to respective side walls of the holding member 10 at such locations that they extend across boundaries of the holding bodies 22, 23. The heating operation of each heater 12 is controlled by a heater control block, not shown, provided with the control unit 14. Further, such a heater 12 may be provided only on one side wall of the holding member 10.

The thermoelectric conversion elements 13 are each comprised of a combination of an n-type and a p-type semiconductor elements and operate to absorb heat at a rate dependent on electric current passing therethrough by the Peltier effect. The elements 13 are rigidly mounted on the top and bottom surfaces (surfaces without the heaters 12 provided thereon) of the holding member 10, as viewed in FIG. 3, respectively, with heat absorption-side surfaces (heat absorption surfaces) thereof in contact with the holding member 10, whereby the holding member 10 is cooled by the elements 13. A surface of each thermoelectric conversion element 13 (heat dissipation surface) opposite to the heat absorption surface is also heated by heat absorbed, and to dissipate the heat, this heat dissipation surface is cooled by water-cooling, as described hereinafter. Each of the elements 13 has a heat absorption amount thereof controlled by a thermoelectric conversion element control block, not shown, provided within the control unit 14. Further, the thermoelectric conversion element 13 of the above-mentioned kind may be provided only on one of the top and bottom surfaces of the holding member 10, as viewed in FIG. 3.

Further, the condenser 4 includes a pair of casings 27, 28 enclosing the whole periphery of the holding member 10 and a pair of lids 29, 30.

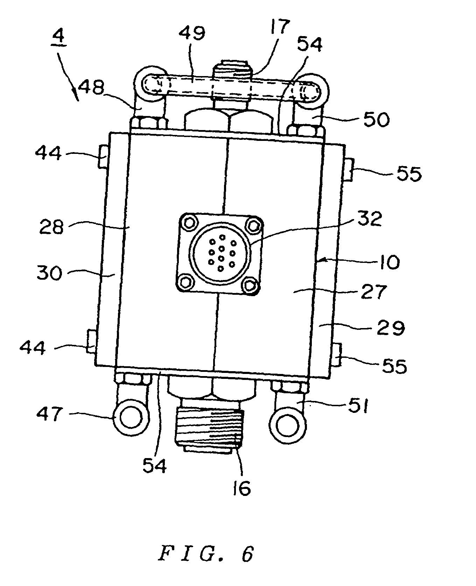

As shown in FIGS. 1 and 3, the casing 27, one of the above casings, is formed with a receiving groove 31 having a shape rectangular in cross-section and receiving the whole of one (23 in the illustrated example) of the pair of holding bodies 22, 23, and a concave portion 33 having a semi-cylindrical shape in cross section for receiving therein a hollow cylindrical portion, not shown, of a connector 32, shown in FIG. 6. The holding body 23 is received in the receiving groove 31 of the casing 27 in a stable manner. On the other hand, the other casing 28 is formed with a receiving groove 34 having a shape rectangular in cross-section and receiving the whole of the other holding body 22, and a concave portion 35 having a semi-cylindrical shape in cross section for receiving therein the hollow cylindrical portion of the connector 32. Further, a gap between the receiving groove 31 of the casing 27 and the holding body 23 and a gap between the receiving groove 34 of the casing 28 and the holding body 22 are filled with thermal insulators.

Further, as shown in FIG. 3, the casing 27 is formed with a water-receiving space 37 having a circular shape and arranged adjacent to the inside of the receiving groove 31 via a thin wall, and an annular groove 39 in which an O-ring 38 is fitted for water-tightly sealing between the casing 27 and the lid 29. Similarly, as viewed in FIGS. 1 and 3, the casing 28 is formed with a water-receiving space 40 having a circular shape and arranged adjacent to the inside of the receiving groove 34 via a thin wall, and an annular groove 42 in which an O-ring 41 is fitted for water-tightly sealing between the casing 28 and the lid 30.

Referring to FIG. 1, the casings 27, 28 are secured to each other at four locations by using bolts 43. Further, the lid 30 is fixed to the casing 28 at four locations by using bolts 44. Similarly, the lid 29 is fixed to the casing 27 at four locations by using bolts 55 (see FIG. 6).

The casing 28 has two through holes 45 formed through portions thereof opposite to each other, for communicating the water-receiving space 40 with the outside of the casing, while the casing 27 has two through holes 46 formed through portions thereof opposite to each other, for communicating the water-receiving space 37 with the outside of the casing 27.

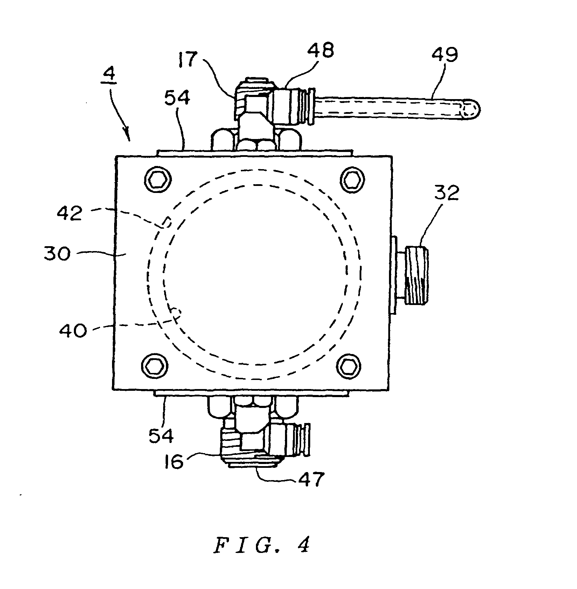

One of the two through holes 45 of the casing 28 has a cooling water tube fitting 47 attached thereto for guiding cooling water (tap water) into the water-receiving space 40, while the other through hole 45 has a cooling water pipe fitting 48 attached thereto (see FIGS. 4 to 6). Further, one of the two through holes 46 of the casing 27 has a cooling water pipe fitting 50 connected to the water-receiving space 40 via the cooling water pipe fitting 48 and a tube 49, while the other through hole 46 has a cooling water pipe fitting 51 attached thereto for discharging cooling water from the water-receiving space 37 to the outside of the casing. As described above, cooling water which has entered the water-receiving space : 40 via the cooling water tube fitting 47 is guided to the water-receiving space 37 via the pipe fitting 48, the tube 49 and the pipe fitting 50, and thereafter discharged from the water-receiving space 37 to the outside by way of the pipe fitting 51. Water-cooling means (auxiliary cooling means) constructed as described above cools the heat dissipation surface of the thermoelectric conversion element 13 by using cooling water. It should be noted that the water-cooling means may be replaced by auxiliary cooling means of a forced-air cooling type which cools the heat dissipation surface by using a fan, auxiliary cooling means of a natural-air cooling type which cools the heat dissipation surface by a cooling plate for spontaneous heat dissipation, or auxiliary cooling means using a heat pipe.

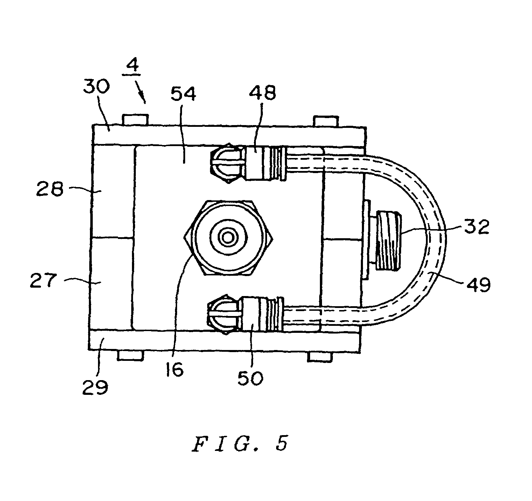

Reference numerals 52, 53 in FIG. 1 designate screw holes for rigidly mounting the connector 32 on the casings 27, 28 by using four screws (see Fig. 6). Further, in FIGS. 5 and 6, reference numeral 54 designates thermal insulators for filling two openings formed between the holding member 10 and the casing 27, 28 on the opposite sides of the holding member 10, and reference numeral 56 in FIG. 2 designates a tape heater for heating the pipe 18 so as to prevent recondensation of the saturated vapor before the saturated vapor reaches the reactor 5.

In the thus-constructed bubbler apparatus according to the embodiment of the invention, when the carrier gas controlled by the mass flow controller 1 at a constant flow rate is blown into the liquid source 3 contained in the bubbler vessel 2 to carry out bubbling of the liquid source 3 by using the carrier gas, a mixture of the carrier gas and the vaporized liquid source 3 as a source gas fills the upper space 7 of the bubbler vessel 2 and is sent to the condenser 4 through the pipe 15. The gas mixture sent from the bubbler vessel 2 to the condenser 4 is preheated by the heater 6 to a predetermined temperature, for instance, to 50 °C. The gas mixture is guided into the pipe 8 of the static mixer 9 in the condenser 4 and mixed by the three pairs of mixing elements 19 as it flows through the mixer pipe 8, such that part of the gas mixture at a peripheral portion of the passage within the mixer pipe 8 and part of the gas mixture at a central portion of the same are replaced with each other, whereby the gas mixture is caused to have a uniform temperature distribution. The heat of the gas mixture is transmitted to the holding member 10 made of the metal material having a high thermal conductivity.

This makes the temperature of the holding member 10 approximately equal to a true temperature of the gas mixture in the mixer pipe 8, and hence by detecting the temperature of the holding member 10 by the temperature sensor 11, it is possible to detect a temperature value close to the true temperature of the gas mixture in the mixer pipe 8. The heaters 12 and the thermoelectric conversion elements 13 are controlled by the control unit 14 such that the temperature detected by the temperature sensor 11 becomes equal to a desired temperature, e.g. 40°C, which enables the vaporized source in the gas mixture flowing in the mixer pipe 8 to constantly condense at a fixed and desired temperature.

As a result, according to the present embodiment, it is possible to always obtain a saturated vapor of the source material at the desired temperature as well as always feed the deposition source material contained in the mixture gas in a predetermined concentration as the saturated vapor from the condenser 4 to the reactor 5.

Further, according to the present embodiment, if the relationship between a temperature at which the vaporized source in the gas mixture is caused to condense by the condenser 4 and a concentration in which the vaporized source is contained in the gas mixture when the condensation is effected by the condenser 4 is determined in advance by using a real-time gas concentration meter, so long as only the temperature at which the vaporized source in the gas mixture condenses is kept constant, the vaporized source, i.e. deposition source material is always supplied in a fixed concentration, even if the flow rate of the carrier gas is varied. As a result, the flow rate of the carrier gas and the feed rate of the source (the amount of the source taken out of the bubbler vessel 2 to the reactor 5 per unit time) come to have a linear relationship or proportionality (in the case of a solid source, the aforementioned constant K as a proportionality constant is approximately equal to 1). Therefore, to increase the amount of the source material to be deposited (e.g. thickness of the deposition) by two times, it is only required e.g. in the case of a solid source that the flow rate of the carrier gas is increased by two times, so that it is possible to easily control the amount of the deposition source material taken out of the bubbler apparatus to the reactor per unit time.

Further, according to the present embodiment, the pipe 8 of the static mixer 9 is straight and connected to the pipe 15 in a manner continuing upward from the pipe 15. Moreover, the internal diameter of the pipe fitting 16 on the mixture inlet side of the pipe 8 is made sufficiently large so as to prevent the condensed liquid source from joining to the liquid source adhering to the inner wall of the pipe fitting 16 and closing the pipe hole as the passage of the gas mixture to block off the mixture flowing therein, so that the liquid source condensed from the vaporized source and dropping in the mixer pipe 8 is caused to positively return to the bubbler vessel 2 without blocking the gas mixture from entering the mixer pipe 8. Thus, the condensed liquid source is prevented from filling the pipe 8, which makes it possible to dispense with a countermeasure against the blocked pipe 8 as well as obtain saturated vapor of the source in a stable state.

Furthermore, according to the present embodiment, the cooling means for cooling the holding member 10 is comprised of the thermoelectric conversion elements 13 each having a heat absorption surface in contact with the outer surface of the holding member 10 for cooling the same, and the water-cooling means (auxiliary cooling means) for cooling the heat dissipation surface of each thermoelectric conversion element 13. Therefore, the holding member 10 is cooled by the heat absorption surface of each thermoelectric conversion element 13, while the heat dissipation surface of each thermoelectric conversion element 13 is cooled by the water-cooling means, which makes it possible to efficiently cool the condenser 4 to a desired temperature, whereby the cooling means can preserve the desired temperature of the condenser in a manner highly responsive to a change therein.

It should be noted that the mixing elements 19 of the static mixer 9 are made of the above-mentioned material having a high thermal conductivity, whereby the temperature of the holding member 10 detected by the temperature sensor 11 is made closer to the true temperature of the gas mixture, enabling control of the temperature of the condenser 4 with higher accuracy in response to the detected temperature closer to the true temperature of the gas mixture. This makes it possible for the condenser 4 to cause the vaporized source in the gas mixture to constantly condense at a predetermined temperature.

Although in the present embodiment, both the heaters 12 and the thermoelectric conversion elements 13 are controlled by the control unit 14 such that the temperature detected by the temperature sensor 11 becomes equal to a desired temperature, e.g. 40 °C, this is not limitative, but to effect condensation of the vaporized source in the gas mixture at a low temperature, the condenser 4 may be configured such that only the thermoelectric conversion elements 13 are controlled by the control unit 14, or alternatively, to effect condensation of the same at a high temperature, the condenser 4 may be configured such that only the heaters 12 are controlled by the control unit 14.

Further, in the present embodiment, not only the liquid source but also a solid source, such as TMI (trimethyl indium), can be used.

As a variation of the present embodiment, the pipe 8 of the static mixer 9 and the holding member 10 may be made of a material having a high thermal conductivity such that they form a unitary flow path-forming member defining therein a through hole for the gas mixture to flow therethrough, whereby a temperature of the flow path-forming member may be detected by the temperature sensor 11. By configuring the condenser 4 as described above, the heat of the gas mixture flowing through the through hole of the flow path-forming member is directly transmitted to the flow path-forming member made of the material having a high thermal conductivity, and at the same time the temperature of the flow path-forming member is detected by the temperature sensor 11. Hence, the temperature detected by the temperature sensor 11 is made closer to the true temperature of the gas mixture, so that it becomes possible to control the temperature of the condenser 4 with higher accuracy based on the thus detected temperature closer to the true temperature of the gas mixture. This makes it possible for the condenser 4 to cause the vaporized source in the gas mixture to constantly condense at a predetermined temperature.

Further, the bubbler apparatus according to the present embodiment can be applied to a gas-laser oscillator, to thereby stably feed a source contained in a gas mixture in a predetermined concentration to the gas-laser oscillator. In this case, the gas-laser oscillator itself corresponds to the reactor 5, described above, to serve as a reactor block to which is fed the vaporized source in the gas mixture in a predetermined concentration.

As described hereinabove, according to the bubbler apparatus of the invention, it is possible to feed the source to the reactor block in a fixed concentration in the gas mixture to thereby maintain a constant rate of feed thereof to the reactor block.

Further, according to the condenser for use with the bubbler apparatus of the invention, it is possible to always maintain its temperature at a predetermined temperature, thereby permitting the vaporized source in the mixture to condense at a fixed temperature.

## Claims

1. A condenser (4) for use in cooling a gas mixture of a carrier gas and a source (3) supplied from a bubbler vessel (2) of a bubbler apparatus to a desired temperature at which condensation of said source occurs to thereby provide a saturated vapor of said source at said desired temperature,
said condenser comprising:
a static mixer (9) which can be connected to a piping, wherein said static mixer includes:
a pipe (8) defining a passage through which flows said gas mixture supplied from said bubbler vessel; and
at least one pair of mixing elements (19) for mixing and stirring said gas mixture flowing through said pipe in a manner such that part of said gas mixture at a peripheral portion of said passage and part of said gas mixture at a central portion of said passage are replaced with each other;
a holding member (10) made of a material having a high thermal conductivity and enclosing a whole periphery of said mixer;
a temperature sensor (11) attached to said holding member, for detecting the temperature of said holding member;
temperature adjust means for adjusting the temperature of said holding member comprising at least one of heating means for heating the holding member and cooling means for cooling the holding member;
and
control means for controlling the at least one of the heating means and the cooling means in response to a temperature value detected by said temperature sensor in a manner such that said gas mixture flowing through said static mixer is maintained at a predetermined temperature.

2. A condenser according to Claim 1, wherein said mixing elements of said static mixer are made of a material having a high thermal conductivity.

3. A condenser according to Claim 1 or Claim 2, wherein said pipe of said static mixer and said holding member are made of a material having a high thermal conductivity in a manner such that said pipe and said holding member form a unitary flow path-forming member, said flow path-forming member defining a through hole therein through which said gas mixture flows and which is provided with said at least one pair of mixing elements therein, said temperature sensor detecting the temperature of said flow path-forming member.

4. A condenser according to Claim 1, wherein said cooling means comprises:
thermoelectric conversion elements (13) arranged in a manner such that said thermoelectric conversion elements each have a heat absorption surface thereof in contact with an outer surface of said holding member, for cooling said holding member; and
auxiliary cooling means for cooling a heat dissipation surface of each of said thermoelectric conversion elements.

5. A bubbler apparatus comprising a condenser as claimed in any proceeding claim and further comprising a bubbler vessel holding a source and having a carrier gas blown therein at a controlled flow rate to provide a gas mixture of said carrier gas and said source by bubbling, and a condenser for cooling said gas mixture to a desired temperature at which condensation of said source occurs to provide a saturated vapor of said source at said desired temperature, said source contained in said gas mixture in a desired concentration as said saturated vapor being fed to a reactor block.

## Patentansprüche

1. Kondensator (4) zur Verwendung beim Kühlen einer Gasmischung aus einem Trägergas und einer Quelle (3), die aus einem Sprudelbehälter (2) einer Sprudelvorrichtung zugeführt wird, auf eine gewünschte Temperatur, bei der das Kondensieren der Quelle eintritt, um so einen gesättigten Dampf dieser Quelle mit der gewünschten Temperatur zu erhalten,
wobei der Kondensator aufweist:
einen Statikmischer (9), der mit einer Rohrleitung verbindbar ist, wobei der statische Mischer aufweist:
ein Rohr (8), das einen Durchlaß bildet, durch welchen die aus dem Sprudelbehälter gelieferte Gasmischung strömt; und
zumindest zwei Mischelemente (19) zum derartigen Mischen und Rühren der durch das Rohr strömenden Gasmischung, daß ein Teil der Gasmischung am Randbereich des Durchlasses und ein Teil der Gasmischung im Mittelbereich des Durchlasses durch den jeweils anderen ersetzt wird;
ein aus einem Material mit einer hohen thermischen Leitfähigkeit bestehendes Halteteil (10), das den gesamten Umfang des Mischers umgibt;
einen an dem Halteteil angebrachten Temperatursensor (11) zum Erkennen der Temperatur des Halteteils;
eine Temperatureinstelleinrichtung zum Einstellen der Temperatur des Halteteils, die mindestens entweder eine Heizeinrichtung zum Erwärmen des Halteteils oder eine Kühleinrichtung zum Kühlen des Halteteils aufweist; und
eine Regeleinrichtung zum Regeln mindestens der Heizeinrichtung und/oder der Kühleinrichtung in Reaktion auf einen vom Temperatursensor erkannten Temperaturwert, so daß die durch den Statikmischer strömende Gasmischung auf einer vorbestimmten Temperatur gehalten wird.

2. Kondensator nach Anspruch 1, bei dem die Mischelemente des Statikmischers aus einem Material mit hoher thermischer Leitfähigkeit bestehen.

3. Kondensator nach Anspruch 1 oder Anspruch 2, bei dem das Rohr des Statikmischers und das Halteteil aus einem Material mit hoher thermischer Leitfähigkeit bestehen, so daß das Rohr und das Halteteil ein einteiliges Strömungswegbildungsteil bilden, das ein durchgehendes Loch aufweiset, durch welches die Gasmischung strömt und in welchem die wenigstens zwei Mischelemente vorgesehen sind, wobei der Temperatursensor die Temperatur des Strömungswegbildungsteils erkennt.

4. Kondensator nach Anspruch 1, bei dem die Kühleinrichtung aufweist:
thermoelektrische Wandlerelemente (13), die derart angeordnet sind, daß die thermoelektrischen Wandlerelemente zum Kühlen des Halteteils jeweils mit einer Wärmeabsorptionsfläche in Kontakt mit einer Außenfläche des Halteteils stehen; und
eine Hilfskühleinrichtung zum Kühlen einer Wärmeableitfläche jedes der thermoelektrischen Wandlerelemente.

5. Sprudelvorrichtung mit einem Kondensator nach einem der vorhergehenden Ansprüche und ferner mit einem eine Quelle enthaltenen Sprudelbehälter, in den ein Trägergas mit einer geregelten Strömungsrate eingeblasen wird, um eine Gasmischung aus dem Trägergas und der Quelle durch Sprudeln zu bilden, und einem Kondensator zum Kühlen der Gasmischung auf eine gewünschte Temperatur, bei der das Kondensieren der Quelle erfolgt, um einen gesättigten Dampf der Quelle mit der gewünschten Temperatur zu erhalten, wobei die Quelle, die in der Gasmischung in einer gewünschten Konzentration enthalten ist, als der gesättigte Dampf einem Reaktorblock zugeführt wird.

## Revendications

1. Condensateur (4) pour utilisation pour le refroidissement d'un mélange gazeux d'un gaz porteur et d'une source (3) fournie par un réservoir bouillonneur (2) d'un appareil bouillonneur, à une température souhaitée à laquelle une condensation de ladite source se produit, afin de fournir ainsi une vapeur saturée de ladite source à ladite température souhaitée,
ledit condensateur comprenant :
un mélangeur statique (9) qui peut être relié à un tuyau, dans lequel ledit mélangeur statique comprend :
un tuyau (8) définissant un passage dans lequel s'écoule ledit mélange gazeux fourni par ledit réservoir bouillonneur ; et
au moins une paire d'éléments de mélange (19) pour mélanger et brasser ledit mélange gazeux s'écoulant dans ledit tuyau de telle sorte qu'une partie dudit mélange gazeux à une partie périphérique dudit passage et une partie dudit mélange gazeux à une partie centrale dudit passage soient remplacées l'une par l'autre ;
un élément de support (10) constitué d'un matériau possédant une conductivité thermique élevée, et enfermant une périphérie totale dudit mélangeur ;
un capteur de température (11) relié audit élément de support, pour détecter la température dudit élément de support ;
un moyen d'ajustement de température pour ajuster la température dudit élément de support, comprenant au moins l'un d'un moyen de chauffage pour chauffer l'élément de support et d'un moyen de refroidissement pour refroidir l'élément de support ;
et
un moyen de contrôle pour contrôler l'un au moins du moyen de chauffage et du moyen de refroidissement en réponse à une valeur de température détectée par ledit capteur de température de telle sorte que ledit mélange gazeux s'écoulant dans ledit mélangeur statique soit maintenu à une température prédéterminée.

2. Condensateur selon la revendication 1, dans lequel lesdits éléments de mélange dudit mélangeur statique sont constitués d'un matériau possédant une conductivité thermique élevée.

3. Condensateur selon la revendication 1 ou la revendication 2, dans lequel ledit tuyau dudit mélangeur statique et ledit élément de support sont constitués d'un matériau possédant une conductivité thermique élevée de telle sorte que ledit tuyau et ledit élément de support forment un élément de formation de trajet d'écoulement unitaire, ledit élément de formation de trajet d'écoulement définissant un trou traversant à l'intérieur, dans lequel ledit mélange gazeux s'écoule, et qui est muni de ladite paire d'éléments de mélange au moins à l'intérieur, ledit capteur de température détectant la température dudit élément de formation de trajet d'écoulement.

4. Condensateur selon la revendication 1, dans lequel ledit moyen de refroidissement comprend :
- des éléments de conversion thermoélectrique (13) agencés de telle sorte que lesdits éléments de conversion thermoélectrique aient chacun une surface d'absorption de chaleur en contact avec une surface extérieure dudit élément de support, pour refroidir ledit élément de support ;
et
- un moyen de refroidissement auxiliaire pour refroidir une surface de dissipation de chaleur de chacun desdits éléments de conversion thermoélectrique.

5. Appareil bouillonneur comprenant un condensateur selon l'une quelconque des revendications précédentes et comprenant en outre un réservoir bouillonneur renfermant une source et possédant un gaz porteur soufflé à l'intérieur à un débit contrôlé afin de fournir un mélange gazeux dudit gaz porteur et de ladite source par bouillonnage, et un condensateur pour refroidir ledit mélange gazeux à une température souhaitée à laquelle une condensation de ladite source se produit afin de fournir une vapeur saturée de ladite source à ladite température souhaitée, ladite source contenue dans ledit mélange gazeux à une concentration souhaitée en tant que vapeur saturée étant fournie à un bloc réacteur.
